Europäisches Patentamt

European Patent Office

Office européen des brevets

(19)

(11) Numéro de publication: **0 024 496**
**A1**

(12) # DEMANDE DE BREVET EUROPEEN

(21) Numéro de dépôt: **80103545.2**

(22) Date de dépôt: **24.06.80**

(51) Int. Cl.³: **H 03 K 5/15**

(30) Priorité: **28.08.79 FR 7922137**

(43) Date de publication de la demande:
**11.03.81 Bulletin 81/10**

(84) Etats Contractants Désignés:
**DE FR GB**

(71) Demandeur: **International Business Machines
Corporation**

**Armonk, N.Y. 10504(US)**

(72) Inventeur: **Grandguillot, Michel
16, rue des Chênes
F-91540 Mennecy(FR)**

(72) Inventeur: **Mollier, Pierre
15, rue de Ponthierry
F-77310 Boissise le Roi(FR)**

(72) Inventeur: **Nuez, Jean-Paul
34, rue des Coquelicots
F-91540 Mennecy(FR)**

(74) Mandataire: **Colas, Alain
COMPAGNIE IBM FRANCE Département de Propriété
Industrielle
F-06610 - La Gaude(FR)**

(54) **Circuit générateur de signaux clair/complément.**

(57) Circuit générateur de signaux qui, en réponse à un signal d'entrée, délivre, sur ses sorties, des signaux clair/complément en opposition de phase. Ce circuit comporte un bloc récepteur (REC10) recevant le signal d'entrée (VE) et délivrant des signaux d'attaque sur ses sorties (A) et (B), et deux blocs générateurs de signaux de commande (GSC11) et (GSC12) qui reçoivent respectivement les signaux d'attaque apparaissant en (A) et (B) et qui délivrent les signaux clair (S) et complément ($\overline{S}$) sur leur sortie. Ce circuit peut être utilisé pour la recherche de lignes d'adresses dans les dispositifs décodeurs de mémoire.

FIG.2

EP 0 024 496 A1

CIRCUIT GENERATEUR DE SIGNAUX
CLAIR/COMPLEMENT

## Description

### Domaine Technique

La présente invention concerne un circuit électrique qui, en réponse à un signal d'entrée, délivre des signaux clair/complément sur ses sorties.

### Etat de la Technique

Le principe des circuits générateurs de signaux clair/compléments est bien connu par l'homme de l'art. Ces circuits sont utilisés dans de nombreuses applications telles que la détermination de lignes d'adresses clair/complément dans les dispositifs décodeurs de mémoire. Ces circuits, en réponse à un signal d'entrée, délivrent des valeurs de signaux clair/complément à leurs sorties. Pour satisfaire aux exigences de rapidité de commutation et d'immunité aux bruits, ces circuits sont complexes, encombrants lorsqu'il faut les intégrer sur des pastilles semi-conductrices et, généralement, leur vitesse de commutation s'en trouve ralentie. De plus, leur agencement ne permet pas d'obtenir une symétrie entre la sortie claire et la sortie complément, ce qui nuit à leur fonctionnement.

Un exemple de tels circuits comprend un bloc récepteur qui reçoit le signal d'entrée et qui délivre un signal de commande, deux blocs générateurs de signaux de commande dont l'un reçoit directement le signal de commande et délivre un signal clair, et dont l'autre, qui est relié par l'intermédiaire d'un inverseur au signal de commande, délivre le signal complément.

Les blocs générateurs de signaux ont des structures semblables à celles de l'inverseur et l'ensemble du circuit présente une structure complexe, dissymétrique et relativement peu rapide.

Exposé de l'Invention

La présente invention a pour objet un circuit générateur de signaux clair/complément qui présente une vitesse de commutation élevée, une structure simple et qui puisse être intégrée dans des pastilles semi-conductrices dans un minimum de place tout en conservant une très bonne immunité aux bruits apparaissant avec les tensions d'entrée.

Ces objets sont atteints avec le circuit générateur de signaux clair/complément de la présente invention qui, en réponse à un signal d'entrée, engendre des signaux clair/complément, et qui est caractérisé en ce qu'il comporte:

. un premier bloc récepteur comportant un premier transistor de commutation dont la base reçoit le signal d'entrée et qui délivre respectivement deux signaux de commande sur ses électrodes de collecteur et d'émetteur,

. un premier bloc générateur de signaux de commande comportant un second transistor de commutation dont la base est reliée au collecteur dudit premier transistor à travers un premier élément de décalage du niveau de tension et dont le collecteur délivre le signal clair et,

. un second bloc générateur de signaux de commande comportant un troisième transistor de commutation dont la base est reliée à l'émetteur du premier transistor et dont le collecteur délivre le signal complément.

D'autres objets, caractéristiques et avantages de la présente invention ressortiront mieux de l'exposé qui suit, fait en référence aux dessins annexés à ce texte, qui représentent un mode de réalisation préféré de celle-ci.

3

## Brève Description des Figures

La figure 1 représente un circuit générateur de signaux clair/complément de l'art antérieur.

La figure 2 représente un circuit générateur de signaux conforme à la présente invention.

## Description de l'Invention

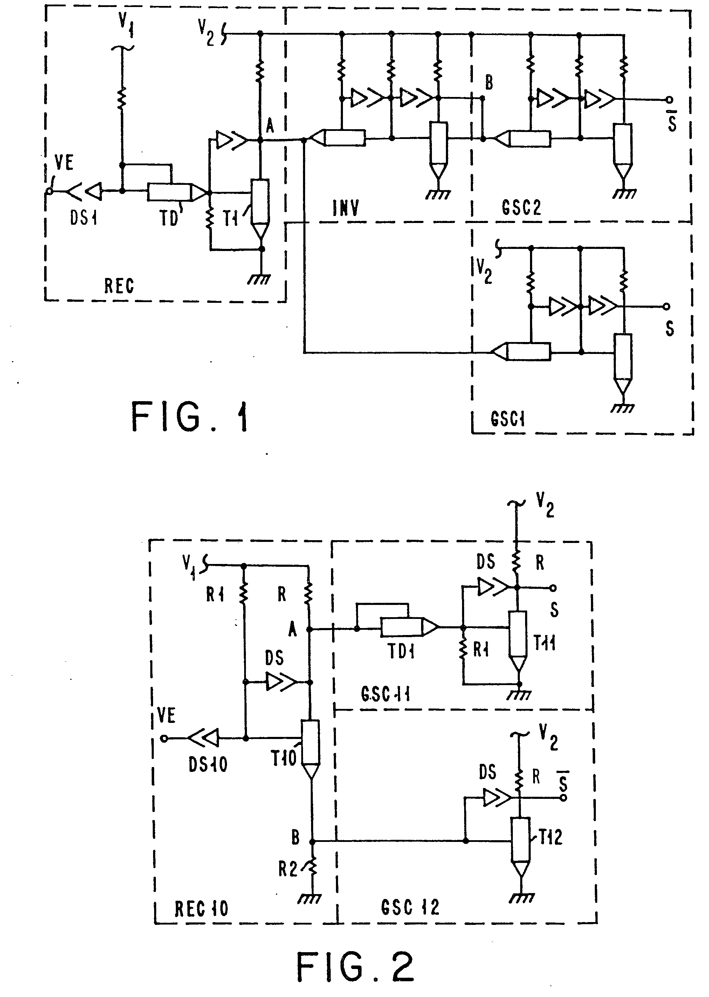

Le circuit représenté à la figure 1 est bien connu en soi et représente un générateur de signaux clair/complément constitué principalement de quatre blocs à savoir un bloc récepteur REC, recevant le signal d'entrée VE et délivrant un signal d'attaque à sa sortie (noeud A), un premier bloc générateur de signaux de commande GSC1 recevant directement le signal d'attaque et délivrant le signal clair S à sa sortie, un bloc inverseur INV qui transforme le signal d'attaque (noeud A) en un signal inverse délivré en B et enfin un second bloc générateur de signaux de commande GSC2 qui reçoit le signal apparaissant en B et délivre le signal complément $\overline{S}$ à sa sortie.

Le fonctionnement du bloc inverseur, ainsi que celui des blocs GSC1 et GSC2 qui lui est similaire, est bien connu, c'est-à-dire que chacun de ces blocs délivre un signal de sortie inverse au signal d'entrée reçu. Le bloc récepteur comporte principalement un transistor de commutation T1 et une diode de Schottky DS1 qui permet d'adapter le niveau du récepteur à celui du signal VE, l'ensemble DS1, TD, T1 permettant d'assurer au circuit l'immunité aux bruits du signal d'entrée.

Le fonctionnement d'un tel circuit est défini par le niveau du signal d'entrée.

Si VE est à un niveau haut, le transistor T1 conduit et le noeud A est à un niveau bas. Les trois blocs INV, GSC1 et

4

GSC2 fonctionnant comme inverseurs, le point B sera porté à un niveau haut et la sortie $\overline{S}$ sera à un niveau bas tandis que la sortie S sera à un niveau haut.

Si VE est à un niveau bas, le transistor T1 est bloqué portant le noeud A à un niveau haut. La sortie S délivrera un niveau bas tandis que la sortie $\overline{S}$ délivrera un niveau haut.

Il est à remarquer que les noeuds A et B qui ont des niveaux inversés, ne peuvent être considérés comme sorties clair/complément, car dans cette hypothèse, la charge apparaissant en A ralentirait considérablement la vitesse de commutation du circuit qui ne serait alors plus performant.

Un tel circuit générateur de signaux clair/complément présente l'inconvénient d'être relativement peu rapide, de comporter une dissymétrie importante due à la présence du bloc inverseur, et d'avoir une structure relativement complexe ce qui se traduit par une surface d'intégration du circuit relativement importante.

Le circuit de la présente invention tel que représenté sur la figure 2 permet de pallier ces inconvénients. Ce circuit se compose d'un bloc récepteur REC 10 et de deux blocs générateurs de signaux de commande GSC11 et GSC12.

Le bloc récepteur comporte principalement un transistor de commutation T10 dont la base est attaquée par les signaux d'entrée VE à travers une diode de Schottky DS10. Cette dernière sert d'élément de décalage de niveau de tension et permet d'adapter le niveau du récepteur à celui du signal d'entrée VE. Cette diode DS10 peut également avoir un rôle de découplage dans le cas où le signal d'entrée VE attaque plusieurs circuits générateurs de signaux en parallèle. Elle permet, dans ce cas de maintenir un signal d'entrée compatible pour tous les étages de circuits en parallèle.

En tant qu'élément de décalage de niveau de tension, la diode DS10 pourrait être remplacée par tout dispositif équivalent tel qu'une résistance.

Le bloc récepteur délivre deux signaux d'attaque sur les noeuds A et B connectés respectivement au collecteur et à l'émetteur du transistor T10.

Le bloc générateur de signaux de commande GSC11 comporte un transistor TD1 monté en diode, c'est-à-dire un transistor ayant sa jonction collecteur/base court-circuitée, dont le collecteur reçoit les signaux d'attaque apparaissant au noeud A et dont l'émetteur est relié à la base d'un transistor de commutation T11. La sortie S de ce bloc GSC11 est reliée au collecteur du transistor T11 et délivre le signal clair S. Le transistor TD1 est un élément de décalage de niveau et permet d'adapter le niveau du signal d'attaque apparaissant en A à un niveau compatible à la commande de la base du transistor T11. Bien que d'autres éléments, tels qu'une résistance, pourraient être utilisés pour jouer le rôle d'élément de décalage de niveau, l'utilisation d'un transistor monté en diode donne de meilleurs résultats en ce qui concerne l'atténuation des signaux.

Le bloc générateur GSC12 comporte un transistor de commutation T12 dont la base est reliée au noeud B et sur le collecteur duquel est délivré le signal de sortie complément $\overline{S}$.

Dans ce circuit, les diodes DS sont des diodes anti-saturation et les résistances R, R1 et R2 sont respectivement des résistances de charge de collecteur, de commande de la base et de charge d'émetteur dont le fonctionnement est bien connu.

Un tel circuit délivre des signaux de sortie en opposition et dont le niveau dépend du signal d'entrée.

Si le signal VE est à un niveau haut, le transistor T10

6

conduit et les noeuds A et B sont respectivement à des niveaux bas et haut. Le noeud A étant à un niveau bas, le transistor T11 est bloqué et la sortie S est à un niveau haut. Dans le même temps, le niveau haut du noeud B impose la conduction du transistor T12 et la sortie $\overline{S}$ est à un niveau bas.

De la même façon, si le signal d'entrée VE est à un niveau bas, le transistor T10 est bloqué et le noeud A sera à un niveau haut tandis que le noeud B sera à un niveau bas. Le signal clair S sera à un niveau bas tandis que le signal complément $\overline{S}$ sera à un niveau haut.

On obtient ainsi à la sortie du circuit deux signaux clair et complément en opposition. Un tel circuit, tout en ayant une bonne immunité aux bruits apparaissant sur les tensions d'entrées, présente une structure simple travaillant à des vitesses de commutation élevée et une bonne symétrie due au fait que les circuits d'attaque apparaissant aux noeuds A et B sont directement envoyés dans les générateurs de signaux de commande GSC11 et GSC12. De plus, ne comportant que peu de composants, ce circuit peut être intégré dans un minimum de surface.

Il est évident que ce circuit n'a été donné qu'à titre d'exemple et que de nombreuses modifications peuvent y être apportées sans sortir du cadre de l'invention. Par exemple, les transistors peuvent être du type PNP au lieu d'être du type NPN comme cela a été représenté. D'autre part, la liaison des transistors de commutation T11 et T12 au transistor T10 peut comporter d'autres éléments dont la fonction reste identique à celle du transistor TD1 ou permet d'adapter les niveaux des signaux de commande des transistors T11 et T12 aux signaux d'attaque apparaissant aux noeuds A et B. Ainsi, il est possible d'ajouter à la liaison existant entre les noeuds A et B et les bases du transistor T11 et T12 des diodes de Schottky permettant d'abaisser les niveaux de tension. Les diodes anti-saturation de ces deux transistors peuvent alors être réalisées par des transistors montés en diode. D'autres modifications de forme ou de détail peuvent être apportées à ce circuit sans pour autant sortir du cadre de ladite invention.

REVENDICATIONS

1. Circuit générateur de signaux clair/complément du genre de ceux qui, en réponse à un signal d'entrée, engendrent des signaux de sortie clair/complément, caractérisé en ce qu'il comporte:

. un premier bloc récepteur (REC 10) comportant un premier transistor de commutation (T10) dont la base reçoit le signal d'entrée (VE) et qui délivre respectivement deux signaux de commande sur ses électrodes de collecteur et d'émetteur,

. un premier bloc générateur de signaux de commande (GSC11) comportant un second transistor de commutation (T11) dont la base est reliée au collecteur dudit premier transistor à travers un premier élément de décalage du niveau de tension et dont le collecteur délivre le signal clair et,

. un second bloc générateur de signaux de commande (GSC12) comportant un troisième transistor de commutation (T12) dont la base est reliée à l'émetteur du premier transistor et dont le collecteur délivre le signal complément.

2. Circuit générateur de signaux selon la revendication 1 caractérisé en ce que le signal d'entrée attaque la base dudit premier transistor de commutation à travers un second élément de décalage du niveau de tension.

3. Circuit générateur de signaux selon la revendication 2 caractérisé en ce que ledit second élément de décalage du niveau de tension est une diode de Schottky.

4. Circuit générateur de signaux selon l'une quelconque des revendications 1 à 3 caractérisé en ce que ledit premier élément de décalage du niveau de tension est un transistor monté en diode.

5. Circuit générateur de signaux selon l'une quelconque des revendications 1 à 4 caractérisé en ce que chacun des blocs générateurs de signaux comportent des moyens de décalage du niveau de tension situés d'une part, entre l'électrode de collecteur du premier transistor de commutation et le premier bloc générateur de signaux et, d'autre part, entre l'électrode d'émetteur du premier transistor de commutation et le second bloc générateur de signaux.

6. Circuit générateur de signaux selon la revendication 5 caractérisé en ce que lesdits moyens de décalage du niveau de tension sont les diodes de Schottky.

FIG. 1

FIG. 2

Office européen
des brevets

**RAPPORT DE RECHERCHE EUROPEENNE**

| Catégorie | Citation du document avec indication, en cas de besoin, des parties pertinentes | Revendication concernée |
|---|---|---|
| X | <u>US - A - 4 005 315</u> (BLAUSCHILD)<br><br> * Colonne 2, lignes 21-37; figure 1 * | 1 |
|  | -- |  |
| X | ELECTRONICS, vol. 34, no. 17, 28 avril 1961<br>New York US<br>"The technology today", pages 73-88<br><br> * Page 76, colonne de droite, avant-dernier alinéa; page 78; figure 9 * | 1,4 |
|  | -- |  |
|  | IBM TECHNICAL DISCLOSURE BULLETIN, vol. 21, no. 2, juillet 1978<br>New York US<br>G.J. GAUDENZI: "Module disable driver", page 622<br><br> * Figure * | 1-3 |
|  | -- |  |
|  | <u>FR - A - 2 105 811</u> (IBM)<br><br> * Page 2, ligne 23 - page 4, ligne 21; figure * | 1,4 |
|  | ---- |  |

**DOCUMENTS CONSIDERES COMME PERTINENTS**

**CLASSEMENT DE LA DEMANDE (Int. Cl. 3)**

H 03 K 5/15

**DOMAINES TECHNIQUES RECHERCHES (Int. Cl. 3)**

H 03 K   5/15
         5/02
         19/08

**CATEGORIE DES DOCUMENTS CITES**

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 04-12-1980 | CANTARELLI |

OEB Form 1503.1   06.78